(19) Europäisches Patentamt
European Patent Office
Office européen des brevets

(11) **EP 1 670 052 B1**

(12) **EUROPÄISCHE PATENTSCHRIFT**

(45) Veröffentlichungstag und Bekanntmachung des Hinweises auf die Patenterteilung:
**20.10.2010 Patentblatt 2010/42**

(21) Anmeldenummer: **04029015.7**

(22) Anmeldetag: **08.12.2004**

(51) Int Cl.:
*H01L 21/8238* (2006.01)     *H01L 21/336* (2006.01)
*H01L 21/266* (2006.01)     *H01L 21/225* (2006.01)
*H01L 21/761* (2006.01)     *H01L 27/092* (2006.01)
*H01L 29/78* (2006.01)     *H01L 29/10* (2006.01)

(54) **Verfahren zur Herstellung einer Halbleiteranordnung mit einer spannungsfesten PMOSFET-Halbleiterstruktur und einer NMOSFET-Halbleiterstruktur**

Method of making a semiconductor device having a voltage withstanding PMOSFET semiconductor structure and an NMOSFET semiconductor structure

Méthode de fabrication d'un dispositif semi-conducteur comportant une structure semi-conductrice à PMOSFET à tenue en tension et une structure semi-conductrice à NMOSFET

(84) Benannte Vertragsstaaten:
**AT BE BG CH CY CZ DE DK EE ES FI FR GB GR HU IE IS IT LI LT LU MC NL PL PT RO SE SI SK TR**

(43) Veröffentlichungstag der Anmeldung:
**14.06.2006 Patentblatt 2006/24**

(73) Patentinhaber: **PREMA Semiconductor GmbH**
**55129 Mainz (DE)**

(72) Erfinder:
• **Grützediek Hartmut Dr.**
**55130 Mainz (DE)**
• **Scheerer Joachim Dr.**
**55130 Mainz (DE)**

(74) Vertreter: **Luderschmidt, Schüler & Partner**
**Patentanwälte**
**John-F.-Kennedy-Strasse 4**
**65189 Wiesbaden (DE)**

(56) Entgegenhaltungen:
WO-A-00/19503     US-A1- 2003 001 206
US-A1- 2004 063 291

**Beschreibung**

Die Erfindung bezieht sich auf ein Verfahren zur Herstellung einer Halbleiteranordnung mit mindestens einer spannungsfesten P-Kanal-MOSFET-Halbleiterstruktur und mindestens einer N-Kanal-MOSFET-Halbleiterstruktur ausgehend von einem P-dotierten Halbleitersubstrat.

Zur Herstellung von PN-Übergängen in Halbleiterbauelementen sind verschiedene Verfahren bekannt zu denen die Diffusion, Epitaxie und Ionenimplantation zählen. Eine kurze Übersicht über die vielfältigen Herstellungsverfahren von Bipolartransistoren ist in dem Zeitschriftenartikel "Advances in Bipolar VLSI" von George R. Wilson in Proceedings ofthe IEEE, Vol. 78, No. 11, 1990, S. 1707 bis 1719 angegeben.

Die WO 00/19503 A1 beschreibt ein Verfahren zur Herstellung von integrationsfähigen Halbleiterbauelementen ausgehend von einem P-dotierten Halbleitersubstrat. Auf das Halbleitersubstrat wird zunächst eine Maske zur Definition eines von einer umlaufenden Kante begrenzten Fensters aufgebracht. Anschließend wird eine N-dotierte Wanne in dem Halbleitersubstrat mittels Hochvolt-Ionenimplantation mit einer Energie erzeugt, die ausreichend hoch ist, dass an der Oberfläche des Halbleitersubstrats eine P-dotierte Innenzone verbleibt, wobei die Randzone der N-dotierten Wanne bis an die Oberfläche des Halbleitersubstrats reicht. Die weiteren die Struktur des Halbleiterbauelements bildenden N-dotierten und/oder P-dotierten Zonen werden dann in der P-dotierten Innenzone des Halbleitersubstrats erzeugt. Das Verfahren ist insofern vorteilhaft, als aufwendige Epitaxie- und Isolationsprozesse entfallen können.

Die bekannten N-Kanal-MOSFETs (NMOSFET) verfügen über zwei N-dotierte Bereiche in einem Halbleitersubstrat, die den Source und Drain des NMOSFET bilden. Source und Drain des NMOSFET sind durch einen P-dotierten Kanalbereich getrennt, der auch als Bulk bezeichnet wird. Damit sind Source und Drain elektrisch durch zwei Sperrschichten voneinander isoliert. Eine elektrisch-isolierte Elektrode, die den Gate des MOSFET bildet, erstreckt sich entlang der Oberfläche des Halbleitersubstrats von der Source zum Drain.

Der P-dotierte Kanalbereich (Bulk) ist im Allgemeinen mit der Source kurz geschlossen. Durch Anlegen einer ausreichend hohen positiven Spannung $U_{GS}$ zwischen Gate und Bulk bzw. Source kann man entlang der Oberfläche des Halbleitersubstrats einen sogenannten Inversionskanal influenzieren, der eine N-leitende Verbindung zwischen Drain und Source herstellt. Reduziert man $U_{GS}$ auf 0 V, so verschwindet der Inversionskanal, und Drain und Source sind wieder voneinander isoliert.

Da die Leitfähigkeit des Inversionskanals jedoch umgekehrt proportional zu der Kanallänge, d.h. dem Abstand von Drain und Source ist, versucht man den Inversionskanal möglichst kurz zu halten (U. Tietze, Ch. Schenk, "Halbleiterschaltungstechnik", 11. Auflage, Springer, Berlin, 1999, S. 214/215).

Bei kleinen Kanallängen muss allerdings die Bulk-Dotierkonzentration ausreichend hoch sein, um einen Punch-Through-Durchbruch. d.h. einen PNP Durchbruch zwischen Drain und Source zu vermeiden.

Wenn die im Allgemeinen sehr hoch dotierten Drain- und Source-Gebiete direkt an die Bulk-Dotierung grenzen, liegen die entsprechenden (Avalanche-) Durchbruchspannungen der PN-Übergänge relativ niedrig. Typisch sind Werte deutlich unter 10 V. Da die gesamte Drain-Source-Spannung $U_{DS}$ an der Sperrschicht zwischen Drain und Bulk abfällt, wird die maximal zulässige $U_{DS}$ durch eine niedrige Drain-Bulk-Durchbruchspannung limitiert.

Bei diskreten spannungsfesten MOS-Transistoren wird dieses Problem dadurch umgangen, dass zwischen dem hoch dotierten Kanalbereich und dem sehr hochdotierten Drain eine schwach dotierte Driftzone angeordnet wird (U. Tietze, Ch. Schenk.). Dadurch erhöht man nicht nur die Drain-Bulk-Durchbruchspannung, sondern vermindert auch die Punch-Through-Gefahr zwischen Drain und Source. Gleichzeitig kann man MOSFETs mit kleinen Kanallängen realisieren.

Bei integrierten spannungsfesten MOS-Transistoren wird der Einfachheit wegen häufig mit einer zusätzlichen Implantation eine schwach dotierte Driftzone implantiert, die jedoch innerhalb der Bulk-Dotierung liegt, d.h. diese überkompensieren muss. Dabei ergibt sich zwangsläufig, dass die Driftzonendotierung höher liegt als die Bulk-Dotierung.

Bei diskreten Leistungs-MOSFET's, wo eine sehr hohe Spannungsfestigkeit angestrebt wird, muss die Driftzone so schwach wie möglich dotiert sein. Daher geht man von einem sehr schwach dotierten Grundmaterial aus, das die Dotierung der Driftzone darstellt, und implantiert bzw. diffundiert die Bulk-Dotierung hinein (U. Tietze, Ch. Schenk).

Unter der Annahme, dass die Driftzone sehr viel schwächer als das Kanalgebiet dotiert ist, kann der PN-Übergang als abrupt betrachtet werden, d.h. die sich bei anliegender Sperrspannung ausbildende Raumladungszone erstreckt sich praktisch ausschließlich in die Driftzone. Um eine bestimmte Spannungsfestigkeit zu erhalten, muss sowohl die Länge der Driftzone als auch die maximal zulässige Dotierung beachtet werden. Je höher die Durchbruchspannung sein soll, um so kleiner muss die Dotierkonzentration in der Driftzone sein.

Die maximale Durchbruchspannung $U_{DG,BD}$ in Abhängigkeit von der Dotierkonzentration in der Driftzone ist gegeben durch

$$U_{DG,BD} = E_{BD}{}^2 * \varepsilon_{Si} * \varepsilon_0 / (2qN),$$

wobei $E_{BD}$ die Durchbruchsfeldstärke, $\varepsilon_{Si}$ die materialabhängige Dielektrizitätszahl, $\varepsilon_0$ die Vakuum-Dielektrizitätskonstante, q die Elementarladung und N die Dotierkonzentration in der Driftzone ist (S. M. Sze, "Physics of semiconductor devices", 2nd Edition Wiley & Sons, New York, 1981, S. 100, GL).

Mit der empirischen Formel für die Durchbruchsfeldstärke an abrupten PN-Übergängen (S. M. Sze, "Physics of semiconductor devices, S. 102).

$$E_{BD} = (4*10^5 \text{ V/cm}^2) / (1 - 1/3*\log_{10}(N/10^{16}\text{cm}^{-3}))$$

erhält man die maximal erreichbare Drain-Gate-Durchbruchspannung in Abhängigkeit von der Dotierkonzentration.

Es zeigt sich, dass eine möglichst niedrige Dotierkonzentration für die Driftzone anzustreben ist, um möglichst hohe Spannungsfestigkeiten zu erreichen. In der Praxis, in der es auf gut reproduzierbare Bauelemente ankommt, ist die Grunddotierung des Halbleitersubstrats (Wafer) die niedrigste verfügbare Dotierkonzentration.

Die Integration eines spannungsfesten P-Kanal-MOSFET (PMOSFET) auf einem P-dotierten Wafer setzt eine N-dotierte Wanne voraus, die das Drain-Gebiet vom Substrat isoliert. Weiterhin muss innerhalb der N-Wanne ein schwach P-dotiertes Gebiet für die Driftzone erzeugt werden. In diese Doppelwanne werden anschließend die Bulk- und die Source-/Drain-Dotierung eingebracht. Es bieten sich verschiedene Möglichkeiten an, die Doppelwanne zu erzeugen.

In Anlehnung an die bekannten Verfahren zur Herstellung von HalbleiterBauelementen ist es naheliegend, zur Erzielung hoher Spannungsfestigkeiten eine schwach P-dotierte Epitaxie-Schicht auf einer hoch dotierten N-Schicht (buried layer) vorzusehen. Dieses Verfahren ist jedoch aufgrund des Epitaxie-Schrittes und der erforderlichen lateralen Isolation technisch anspruchsvoll und kostenintensiv. Darüber hinaus ist das Verfahren aufgrund der langen Diffusionsprozesse langwierig. Ein weiterer Nachteil liegt in der schlechten Flächenausnutzung, die zu großen Bauelementen führt.

Wenn an die Spannungsfestigkeit geringere Anforderungen gestellt werden, kann auf die bekannten Diffusionsprozesse zur Erzeugung eines P-dotierten Gebietes in einer N-dotierten Wanne zurückgegriffen werden. Dabei kommt es jedoch an der Oberfläche im Driftgebiet zu einer mehrfachen Überkompensation von N- und P-Dotierungen, wodurch aus Gründen der Reproduzierbarkeit das minimale Dotierniveau der Driftzone limitiert wird. Folglich kommt dieses Verfahren für spannungsfeste MOSFET-Transistoren nicht in Frage.

Aus der US 2003/001206 A1 ist ein Verfahren zur Herstellung einer spannungsfesten PMOSFET-Halbleiterstruktur mit einem P-dotierten Halbleitersubstrat bekannt. Bei dem bekannten Verfahren wird eine Maske auf das P-dotierte Halbleitersubstrat zur Definition eines von einer umlaufenden Kante begrenzten Fensters aufgebracht. Daraufhin wird eine N-dotierte Wanne in dem P-dotierten Halbleitersubstrat erzeugt. In einer P-dotierten Innenzone der N-dotierten Wanne wird ein P-dotiertes Source-Gebiet, ein P-dotiertes Drain-Gebiet und ein N-dotierter Kanalbereich zwischen dem P-dotierten Source-Gebiet und dem P-dotierten Drain-Gebiet erzeugt. Bei dem bekannten Verfahren wird die N-dotierte Wanne aber nicht mittels Hochvolt-Ionenimplantation mit einer ausreichend hohen Energie erzeugt, dass an der Oberfläche des Halbleitersubstrats die P-dotierte Innenzone verbleibt und die Randzone der N-dotierten Wanne bis an die Oberfläche des Halbleitersubstrats reicht.

Die US 2004/0063291 A1 beschreibt ein Verfahren zur Herstellung von spannungsfesten Halbleiterbauelementen, beispielsweise Leistungshalbleiter-Bauelementen (MOSFETs), auf einem einzigen Halbleiterchip.

Der Erfindung liegt die Aufgabe zu Grunde, ein Verfahren anzugeben, das die Herstellung einer Halbleiteranordnung auf einfache Weise erlaubt, die sowohl mindestens eine spannungsfeste P-Kanal- als auch mindestens eine N-Kanal-MOSFET-Halbleiterstruktur umfasst.

Das erfindungsgemäße Verfahren beruht auf der Erzeugung einer N-dotierten Wanne in einem P-dotierten Halbleitersubstrat mittels Hochvolt-Ionenimplantation, wobei die Energie die Ionenimplantation derart bemessen ist, dass an der Oberfläche des Halbleitersubstrats eine P-dotierte Innenzone verbleibt und die Randzone der N-dotierten Wanne bis an die Oberfläche des Halbleitersubstrats reicht.

Die Erfinder haben erkannt, dass sich die P-dotierte Innenzone der nach dem obigen Verfahren hergestellten Wanne hervorragend als Driftzone für einen P-Kanal-MOSFET eignet. Dies ist darauf zurückzuführen, dass die Konzentration der Dotierung der Innenzone der Konzentration der Grunddotierung des Halbleitersubstrats entspricht, d.h. die niedrigste Konzentration, die noch zuverlässig reproduzierbar ist. Die Spannungsfestigkeit des nach dem erfindungsgemäßen Verfahren hergestellten P-MOSFETs ist nur durch die Grunddotierung des Halbleitersubstrats und die Tiefe der Wanne limitiert.

Der entscheidende Vorteil des erfindungsgemäßen Verfahrens liegt darin, dass mit einem verhältnismäßig einfachen Prozess eine sehr hohe Spannungsfestigkeit erzielt wird. Die Einfachheit des Prozesses drückt sich darin aus, dass die Wanne, das Driftgebiet und die seitliche Isolation der Wanne mit nur einer einzigen Lithografie und Ionenimplantation mit nur einer einzigen Energie erzeugt werden kann.

Es hat sich gezeigt, dass mit der Hochvolt-Ionenimplantation tiefe Wannen erzeugt werden können, die hohe vertikale Durchbruchspannungen zwischen Drain und Wanne zulassen. Die hohe Spannungsfestigkeit wird einerseits mit der hohen Ionenenergie und andererseits mit der schwachen Grunddotierung des Wafers erreicht, die als Dotierung der Driftzone genutzt wird.

Bei einem P-Kanal-MOSFET ist der N-dotierte Kanalbereich und die N-dotierte Wanne vertikal - wenn überhaupt - nur durch eine schwach P-dotierte Zone getrennt. Um die Gefahr eines Punch-Through-Durchbruchs zu verringern, können der Kanalbereich und die Wanne kurzgeschlossen werden. Zur Erhöhung der Spannungsfestigkeit zwischen dem Kanalbereich und dem Drain ist es lediglich erforderlich, einen geeigneten Abstand zwischen dem Drain und dem Kanalbereich einerseits und dem Rand der Wanne andererseits zu wählen. Weiterhin sollten die bekannten Maßnahmen zur Unterdrückung eines Sperrschichtdurchbruchs an der Oberfläche des Halbleitersubstrats ergriffen werden.

Wenn die mittels der Hochvolt-Ionenimplantation geschaffene Ausgangsstruktur hergestellt ist, können die P-Kanal-MOSFET-Halbleiterstrukturen mit den bekannten Prozessschritten erzeugt werden. Vorzugsweise werden die einzelnen Zonen mittels Ionenimplantationen erzeugt. Die Bereiche, in denen Ionen implantiert werden, können mit dem bekannten Maskierungsprozessen definiert werden. Das Maskenmaterial kann aus Fotolack, Metall, Glas oder sonstigen Materialien bestehen. Vorzugsweise wird die Struktur der mittels Masken definierten Zonen, die dotiert werden sollen, durch lithographische Methoden erstellt. Möglich sind auch Kombinationen aus Lithographien und Ätzungen.

Ein besonderer Vorteil des erfindungsgemäßen Verfahrens zur Herstellung spannungsfester P-Kanal-MOSFET-Halbleiterstrukturen in P-dotierten Halbleitersubstraten liegt darin, dass mit nur einer Hochvolt-Implantation eine Halbleiteranordnung sowohl mit einer P-Kanal-MOSFET- als auch einer N-Kanal-MOSFET-Halbleiterstruktur geschaffen werden kann. Dabei wird die P-Kanal-MOSFET-Struktur nach dem obigen Verfahren hergestellt. Zur Erzeugung der N-Kanal-MOSFET-Struktur wird erfindungsgemäß die Breite des Fensters, das von der auf das Halbleitersubstrat aufgebrachten Maske definiert wird, hingegen derart schmal ausgebildet, dass sich die bis an die Oberfläche des Halbleitersubstrats reichenden Randzonen der Wanne an der Substratoberfläche treffen, so dass an der Oberfläche des Substrats eine entsprechende Innenzone nicht verbleibt. Diese "gefüllte" Wanne kann dann in vorteilhafter Weise als Driftzone für die N-Kanal-MOSFET-Struktur genutzt werden. Dabei sind verschiedene Ausführungsformen möglich, bei denen eine oder mehrere Wannen parallel oder rechtwinklig zum Kanalbereich verlaufen.

Im Folgenden werden mehrere Ausführungsbeispiele des erfindungsgemäßen Verfahrens zur Herstellung von MOSFET-Halbleiterstrukturen unter Bezugnahme auf die Zeichnungen näher erläutert.

Es zeigen:

| | |
|---|---|
| Figuren 1a bis 1h | die einzelnen Verfahrensschritte zur Herstellung einer PMOSFET-Halbleiterstruktur in einem P-dotierten Halbleitersubstrat, |
| Figur 2 | das Dotierprofil der mittels Hochvolt-Ionenimplantation erzeugten Wanne in dem Halbleitersubstrat von den Fig. 1a bis 1h, |
| Figuren 3a bis 3h | die einzelnen Verfahrensschritte zur Herstellung einer NMOSFET-Halbleiterstruktur in einem P-dotierten Halbleitersubstrat, |
| Figuren 4a bis 4d | verschiedene Ausführungsbeispiele einer NMOSFET-Halbleiterstruktur mit unterschiedlich angeordneten Kanalbereichen. |

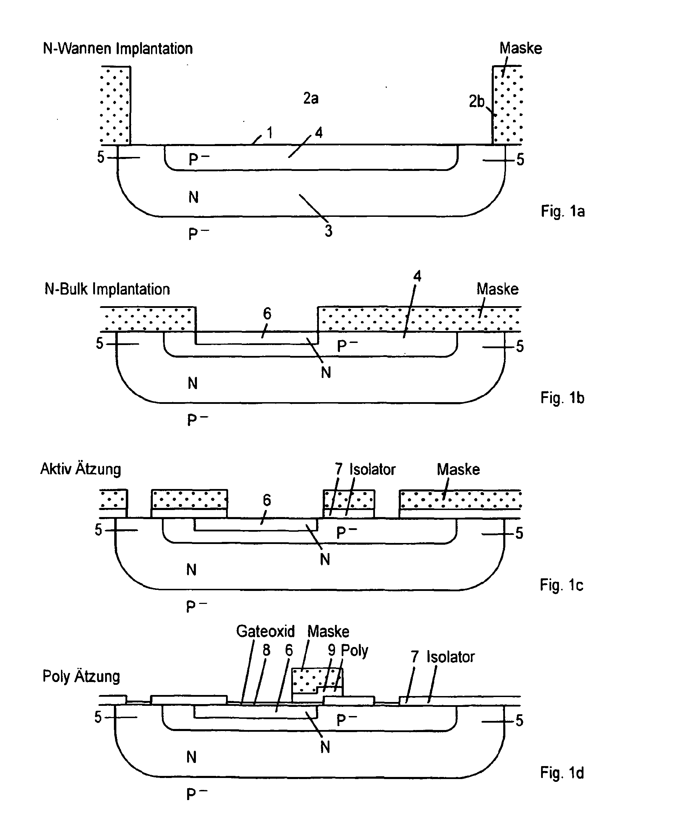

Zur Herstellung einer P-Kanal- MOSFET-Halbleiterstruktur (PMOSFET) wird zunächst die in Figur 1a gezeigte Ausgangsstruktur geschaffen. Hierzu wird auf ein schwach P-dotiertes Halbleitersubstrat 1 (Wafer) eine Maske 2 aufgebracht, die ein Fenster 2a aufweist, das von einer umlaufenden Kante 2b begrenzt wird. Für das Grundmaterial wird vorzugsweise ein Wafer aus schwach P-dotiertem monokristallinem Silizium mit einem Widerstand von z.B. 6 Ω cm verwendet. Weitere geeignete Halbleitermaterialien sind z.B. GaAs und SiC mit den für diese Stoffe geeigneten Dotiermitteln.

Das Maskenmaterial kann aus Fotolack, Metall, Glas oder auch anderen Materialien bestehen. Vorzugsweise wird die Struktur durch fotolithographische Verfahren geschaffen.

Nach der Maskenerstellung erfolgt eine Dotierung, vorzugsweise eine Hochvolt-Implantation, um eine N-dotierte Wanne 3 in dem Halbleitersubstrat 1 zu schaffen. Die Implantationsenergie ist dabei so hoch, dass oberhalb der Wanne 3 in dem Halbleitersubstrat 1 noch eine P-dotierte Innenzone verbleibt ("nicht gefüllte Wanne"). Beispielsweise ist diese Bedingung bei 6 MeV Phosphorionen und einer Dosis von z. B. $2 \times 10^{13}$ Ionen/cm$^2$ trotz der rückgestreuten Phosphorionen erfüllt, wenn das Halbleitersubstrat einen spezifischen Widerstand von 6 Ω cm aufweist. Die nicht gefüllte Wanne kann unter Variation von Ionensorte, Ionenenergie, Implantationsdosis sowie Substratdotierung erzielt werden. Entscheidend ist, dass die Oberflächendotierkonzentration der Wanne deutlich unter der Konzentration der Substratdotierung liegt. Eine niedrige Oberflächendotierkonzentration der Wanne kann erreicht werden durch eine hohe Ionenenergie (bzw. eine hohe Reichweite der Ionen) und/oder eine niedrige Dosis. Eine hohe Substratdotierung erleichtert ebenfalls die Erfüllung der Bedingung zur Erzeugung einer nicht gefüllten Wanne.

Da die Ionen an einer senkrechten Kante eines Maskenfensters gestreut bzw. an schräg verlaufenen Kanten unterschiedlich stark abgebremst werden, bildet sich eine Wanne 3 mit einer nach oben gezogenen Randzone 5 aus, die bis zu der Oberfläche des Halbleitersubstrats 1 reicht und die verbleibende P⁻-dotierte Innenzone 4 an der Oberfläche des Halbleitersubstrats umschließt. Somit ist die P-dotierte Innenzone 4 vom Substratvolumen isoliert. Für die Ausbildung der Randzone ist es unerheblich, ob die Kante 2b des Maskenfensters senkrecht, schräg nach außen oder schräg nach innen überhängend geformt ist.

Die minimale Dicke der Maske 2 ist durch die maximale Reichweite der Ionen im Maskenmaterial festgelegt. Masken mit größerer Dicke verbreitern die Streubereiche am Wannenrand, so dass die Herstellung kleiner Wannen erschwert ist.

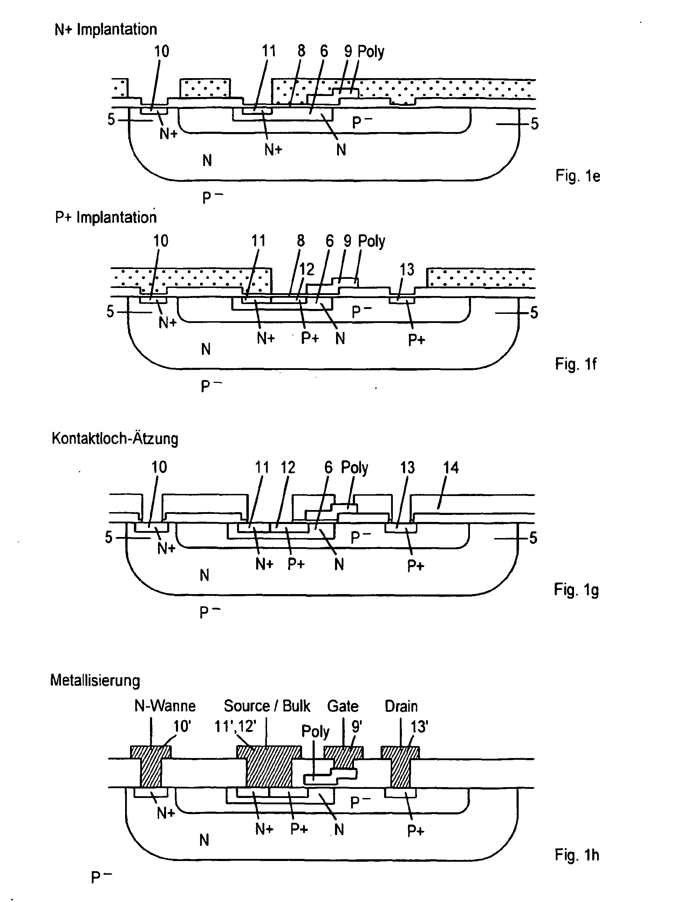

Ausgehend von der in Figur 1a gezeigten Halbleiterstruktur wird die PMOSFET-Halbleiterstruktur mit den nachfolgend beschriebenen Schritten geschaffen (Figuren 1b bis 1h). Der nachfolgend beschriebene Prozessablauf ist aber nur ein Ausführungsbeispiel zur Herstellung einer PMOSFET-Struktur. Daher können auch andere Verfahrensschritte als die beschriebenen zur Schaffung der Struktur durchgeführt werden. Allerdings setzt das erfindungsgemäße Verfahren immer die unter Bezugnahme auf Figur 1 beschriebene Ausgangsstruktur voraus.

Da die einzelnen Verfahrensschritte zur Herstellung von unterschiedlich dotierten Gebieten in einem Halbleitersubstrat dem Fachmann als solche bekannt sind, beispielsweise die Herstellung von Masken und die Strukturierung durch Ätzen, werden nur die wesentlichen Verfahrensschritte zur Herstellung der PMOSFET-Halbleiterstruktur beschrieben.

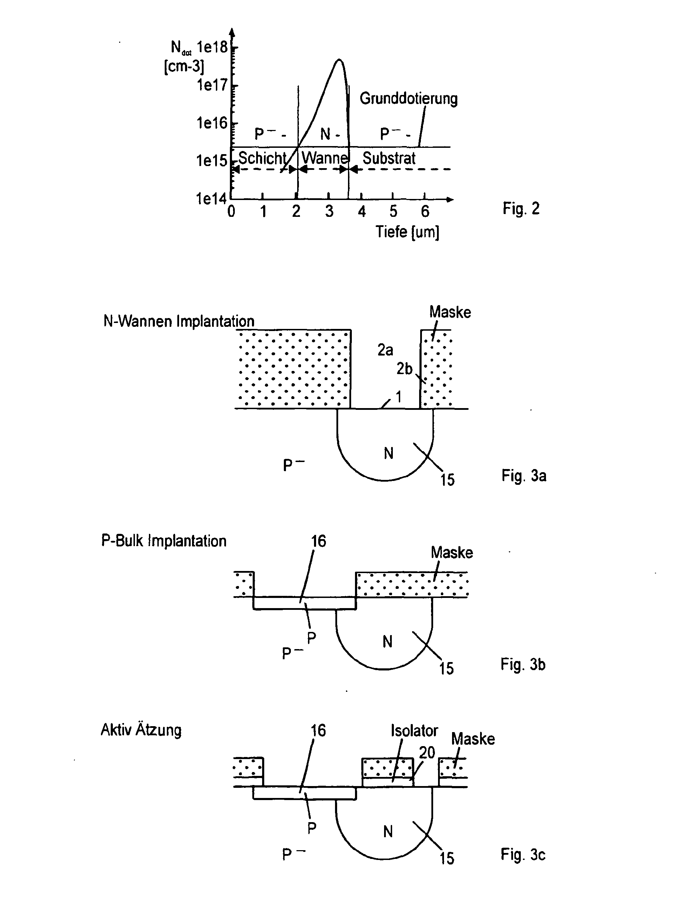

Figur 2 zeigt das Dotierprofil der mittels Hochvolt-Ionentransplantation mit einer Energie von 6 MeV erzeugten Wanne, wobei die Implantationsdosis $2 \times 10^{13}$ /cm² Phosphorionen beträgt, und das P-dotierte Substrat einen Widerstand von 6 $\Omega$ cm hat. Deutlich ist zu erkennen, dass in der von der Wanne eingeschlossenen Innenzone, d.h. der Schicht im Bereich von 0 bis 2 $\mu$m, die Grunddotierung des Halbleitersubstrats verbleibt.

Nach der Herstellung der Ausgangsstruktur wird eine neue Maske auf das Halbleitersubstrat 1 aufgebracht und strukturiert. In der P-dotierten Innenzone 4 wird mittels Ionenimplantation ein N-dotierter Kanalbereich 6 erzeugt (Figur 1b). Nach Entfernen der Maske wird eine Isolator-Schicht 7 auf dem Halbleitersubstrat 1 abgeschieden. Nach Aufbringen einer weiteren Maske wird die Isolatorschicht 7 mittels Ätzung strukturiert (Figur 1c).

Auf den N-dotierten Kanalbereich 6 wird eine Gate-Oxydschicht 8 erzeugt, auf die eine Gateelektrode 9 aus Poly-Silizium abgeschieden und strukturiert wird. Die Gate-Isolierschicht entsteht auch in anderen Öffnungen der Isolatorschicht. Zum Schutz der Kanten der Gate-Oxidschicht vor den nachfolgenden Hochdosis-Implantationen und zur Reduzierung der parasitären Gate-Source- und Gate-Drain-Kapazitäten wird im Allgemeinen noch ein sogenannter Spacer entlang der Gatekanten erzeugt. Der besseren Übersichtlichkeit halber wird dieser als solche bekannte Spacer aber hier nicht gezeigt (Figur 1d).

In dem an die Gateelektrode 9 angrenzenden Bereich des N-dotierten Kanalbereichs 6 und in dem nach oben gezogenen Randbereich 5 der N-dotierten Wanne 3 werden mittels Ionenimplantation N⁺-dotierte Übergangszonen 10, 11 für den Anschluss der Wanne und des Kanalbereichs erzeugt (Figur 1e). Danach folgt ein weiterer Implantationsschritt zur Erzeugung eines P⁺-dotierten Source-Gebietes 12 in dem an die Gateelektrode 9 angrenzenden Bereich des N-dotierten Kanalbereichs 6 und Erzeugung eines P⁺-dotierten Drain-Gebietes 13 in dem Bereich der P-dotierten Innenzone 4, der an den N-dotierten Kanalbereich 6 angrenzt (Figur 1f).

Daran schließt sich die Abscheidung eines zweiten Isolators 14 und ein Temperschritt zur Ausheilung der bei den Implantationen entstandenen Kristallschäden und zur Aktivierung der Dotierstoffe an. Daraufhin werden die Kontaktlöcher für die Anschlüsse der PMOSFET-Halbleiterstruktur geätzt (Figur 1g). Anschließend werden die Anschlusskontakte für den Drain-Anschluss 13', den GateAnschluss 9', den Source/Bulk-Anschluss 11' und 12' sowie den Anschluss 10' für die N-dotierte Wanne 3 beispielsweise durch eine Titansilizid-Bildung formiert. Der Source/Bulk-Anschluss 11' und 12' stellt einen Kurzschluss zwischen dem P⁺-dotierten Source-Gebiet 12 und dem N-dotierten Kanalbereich 6 (Bulk) her. Mit der Ausbildung der Metallisierung ist die PMOSFET-Halbleiterstruktur fertiggestellt (Figur 1h).

Bei der PMOSFET-Halbleiterstruktur liegt die P⁻-dotierte Innenzone 4 in dem Bereich zwischen Gate und Drain 9, 13, und die P⁻-dotierte Innenzone bildet somit die Driftzone des PMOSFET. Da die Dotierung der Driftzone der sehr schwachen Grunddotierung des Halbleitersubstrat entspricht, verfügt der MOSFET über eine hohe Spannungsfestigkeit. Eine ausreichende Länge der Driftzone sowie ausreichende Maßnahmen zur Unterdrückung von Oberflächendurchbrüchen vorausgesetzt, ist die maximale Drain-Source-Spannung $U_{DS}$ nur durch die Durchbruchspannung zwischen Drain-Anschluss und N-Wanne begrenzt.

Die N-leitende Bulk-Dotierung muss nicht notwendigerweise (vertikal) von der N-Wanne isoliert sein, da sie ohnehin mit ihr verbunden wird. Dementsprechend kann sie in der Tiefe ohne weiteres in die Wannendotierung übergehen.

Das erfindungsgemäße Verfahren zeichnet sich dadurch aus, dass mit einfachen Verfahrensschritten eine Halbleiteranordnung, die sowohl mindestens eine Spannungsfeste PMOSFET-Halbleiterstruktur als auch mindestens eine NMOSFET-Halbleiterstruktur umfasst, hergestellt werden kann.

Auf dem Halbleitersubstrat wird zunächst mit den unter Bezugnahme auf die Figuren 1a bis 1h beschriebenen Verfahrensschritten die PMOSFET-Halbleiterstruktur hergestellt. Daraufhin folgt die Herstellung der NMOSFET-Halbleiterstruktur auf demselbem Substrat neben der PMOSFET-Struktur mit den nachfolgenden Schritten.

Während zur Herstellung der PMOSFET-Struktur mittels Hochvolt-Ionenimplantation eine N-dotierte Wanne geschaffen wird, die eine P-dotierte Innenzone umschließt, wird zur Herstellung der NMOSFET-Halbleiterstruktur eine N-dotierte Wanne geschaffen, die bis an die Oberfläche des Halbleitersubstrats reicht. Da diese Wanne bei der NMOSFET-Halbleiterstruktur als Driftzone dient, kann ein weiterer Implantationsschritt zur Herstellung einer derartigen Zone entfallen. Dadurch wird das Verfahren vereinfacht.

Zur Herstellung der "gefüllten Wanne" können die gleichen Verfahrensschritte wie zur Herstellung der "nicht gefüllten Wanne" verwandt werden. Der einzige Unterschied liegt darin, dass das Fenster 2a der Maske für die Hochvolt-Ionenimplantation derart schmal ausgebildet wird, dass sich die hochgezogenen Streubereiche entlang der Wannenkanten in der Wannenmitte treffen. Wenn die Dicke der Maske erhöht wird, verbreitern sich die Streubereiche, was die Herstellung der NMOSFET-Halbleiterstruktur erleichtert.

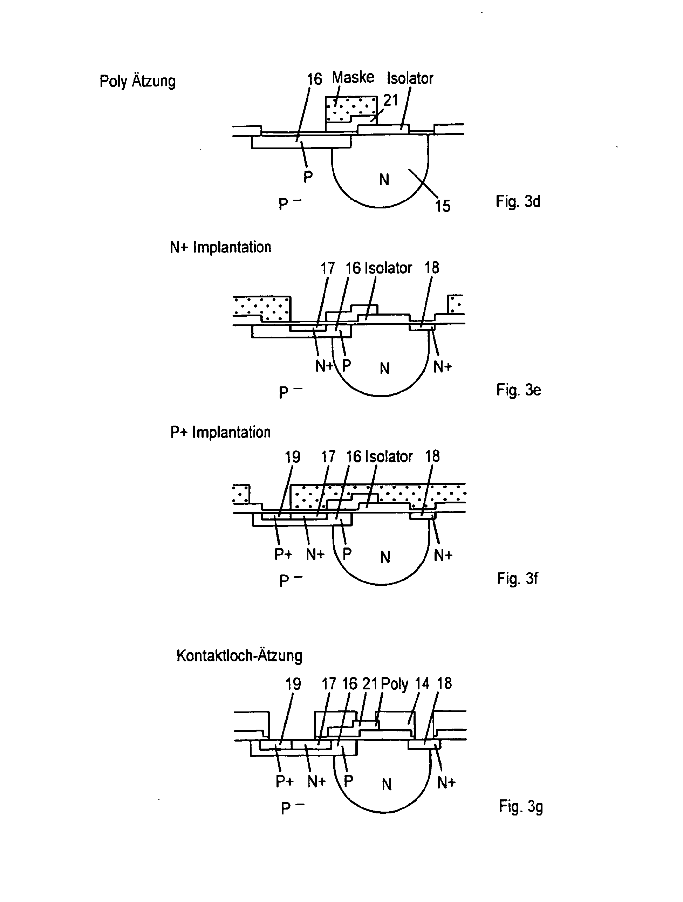

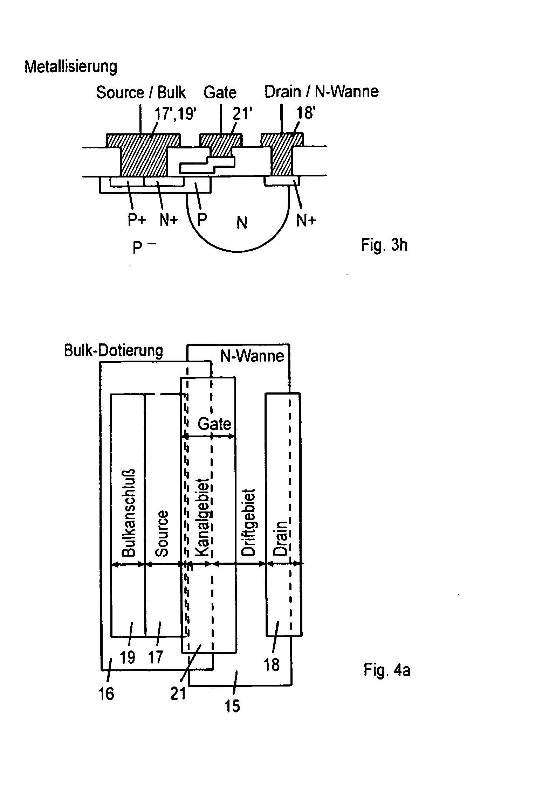

Die Figuren 3a bis 3h zeigen die einzelnen Verfahrensschritte zur Herstellung der NMOSFET-Halbleiterstruktur. Abgesehen von einer weiteren Implantation für das P-dotierte Bulkgebiet erfolgt die Herstellung der NMOSFET-Halbleiterstruktur mit den gleichen Prozessschritten wie die der PMOSFET-Halbleiterstruktur. Die Figuren 3a bis 3h zeigen die Verfahrensschritte am Beispiel eines nicht isolierten NMOSFET, dessen Bulk auf Substrat-Potential liegt. Dieser NMOSFET weist eine N-dotierte Wanne auf, die parallel zum Gate angeordnet ist.

Zunächst wird eine "gefüllte" N-dotierte Wanne 15 in dem schwach $P^-$-dotierten Halbleitersubstrat 1 mittels Hochvolt-Ionenimplantation durch eine Maske 2 erzeugt, die ein schmales Fenster 2a aufweist (Figur 3a). Die N-dotierte Wanne bildet die Driftzone für den NMOSFET. Daraufhin wird ein P-dotierter Kanalbereich 16 in dem Halbleitersubstrat 1 erzeugt, der sich bis in die N-dotierte Driftzone 15 erstreckt (Figur 3b). Nunmehr folgen die gleichen Prozessschritte wie bei der Herstellung der PMOSFET-Halbleiterstruktur, wobei die entsprechenden Dotiergebiete jeweils den invertierten Leitungstyp haben.

Auf dem Halbleitersubstrat 1 wird eine Isolator-Schicht 20 abgeschieden und strukturiert (Figur 3c). Es folgt die Herstellung der Gate-Oxidschicht sowie die Abscheidung und Strukturierung der Gateelektrode 21 aus Polysilizium für den Gateanschluss 21' (Figur 3d). Nunmehr schließen sich die Schritte zur Erzeugung eines $N^+$-dotierten Gebiets 17 und $P^+$-dotierten Gebietes 19 in dem P-dotierten Kanalbereich 16 für den gemeinsamen Source/Bulk-Anschluss 17' und 19' sowie eines $N^+$-dotierten Gebiets 18 im Randbereich der Driftzone 15 für den Drain-Anschluss 18' an, der gleichzeitig den Wannenanschluss bildet (Figuren 3f bis 3h).

Die NMOSFET-Halbleiterstruktur wird direkt in das Halbleitersubstrat gelegt, wobei das Bulk-Gebiet mit dem Substrat verbunden wird. Solange der Source permanent auf dem Potential des Substrats (Masse) liegt, ergeben sich keine Probleme. Wenn das Source-Potential jedoch angehoben wird, so setzt sich durch die Differenzspannung zwischen Source und Bulk eine sogenannte Rückseitensteuerung ein, die die Schwellspannung des MOSFET verschiebt. Dies kann jedoch, wie im folgenden Absatz beschrieben ist, vermieden werden.

Figur 4a zeigt die Anordnung der einzelnen Zonen des Halbleitersubstrats in der Draufsicht bei der unter Bezugnahme auf die Figuren 3a bis 3h beschriebenen Halbleiterstruktur, deren N-Wanne 15 parallel zum Gate 21, d.h. quer zur Stromflussrichtung verläuft. Für die einander entsprechenden Gebiete des Halbleitersubstrats werden gleiche Bezugszeichen verwandt. Da die Breite der N-Wanne 15 durch die Breite der Streubereiche limitiert ist, sollte die N-Wanne möglichst bezüglich der Driftzone zentriert sein. Letztere ist durch die drainseitige Kante der Kanaldotierung und dem Beginn des hochdotierten Draingebietes definiert. Im Gegensatz zu einer flachen Driftzone, bietet die N-Wanne als Driftzone die Möglichkeit bei einem platzsparenden Layout und nicht zu hohen Anforderungen an die Spannungsfestigkeit die Bulk-Dotierung auch komplett in die N-Wanne zu legen. Damit ist eine Isolation von Bulk und Source gegenüber dem Substrat möglich.

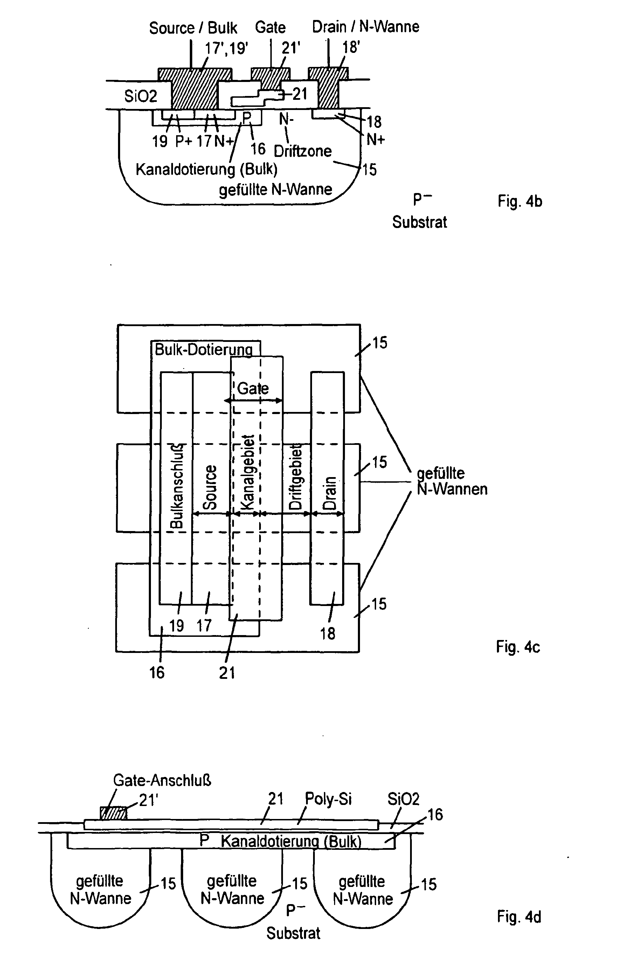

Figur 4b zeigt eine alternative Ausführungsform der NMOSFET-Halbleiterstruktur in vereinfachter schematischer Darstellung, bei der drei parallele N-Wannen 15 senkrecht zum Gate 21 verlaufen. Die einander entsprechenden Gebiete des Halbleitersubstrats sind wieder mit gleichen Bezugszeichen bezeichnet. Die Vorteile gegenüber der Ausführungsform mit der parallel zum Gate verlaufenden Wanne liegen in der Freiheit, die Driftzone beliebig weit ausdehnen zu können und gleichzeitig eine vollständige Isolation bezüglich des Substrats zu erhalten.

Für größere Kanalbreiten können auch mehrere Wannen parallel zueinander angeordnet werden. Die Figuren 4c und 4d zeigen im Querschnitt und in der Draufsicht eine Ausführungsform, bei der drei N-Wannen 15 senkrecht zum Gate orientiert sind. Die Gebiete zwischen den Wannen werden dann entweder durch Streuung unter die Maskenkante ebenfalls durchgehend N-dotiert oder bleiben andernfalls für den MOSFET unwirksam, weil die Driftzone fehlt, wobei im letzteren Fall jedoch das Bulk-Gebiet mit dem Substrat leitfähig verbunden ist.

Die in den Ausführungsbeispielen beschrieben PMOSFET und NMOSFET-Halbleiterstrukturen gehen von einem P-Dotierten Halbleitersubstrat aus. Es ist aber grundsätzlich auch möglich von einem N-dotierten Halbleitersubstrat auszugehen. In diesem Fall werden alle Implantationen durch die komplementäre Spezies ersetzt, d.h. N-Implantationen durch P-Implantationen oder umgekehrt.

**Patentansprüche**

1. Verfahren zur Herstellung einer Halbleiter-Anordnung mit mindestens einer spannungsfesten PMOSFET-Halbleiterstruktur und mindestens einer NMOSFET-Halbleiterstruktur ausgehend von einem P-dotierten Halbleitersubstrat mit den folgenden Schritten:

   Herstellen der mindestens einen PMOSFET-Halbleiterstruktur mit den folgenden Schritten:

   Aufbringen einer Maske (2) auf das P-dotierte Halbleitersubstrat (1) zur Definition eines von einer umlaufenden Kante (2b) begrenzten Fensters (2a),
   Erzeugen einer N-dotierten Wanne (3), in dem P-dotierten Halbleitersubstrat mittels Hochvolt-Ionenimplantation, wobei die Energie der Ionenimplantation derart bemessen ist, dass an der Oberfläche des Halbleitersubstrats eine P-dotierte Innenzone (4) verbleibt und die Randzone (5) der N-dotierten Wanne bis an die Oberfläche des Halbleitersubstrats reicht und
   Erzeugen eines P-dotierten Source-Gebietes (12), eines P-dotierten Drain-Gebietes (13) und eines N-dotierten Kanalbereichs (6) zwischen dem P-dotierten Source-Gebiet und dem P-dotierten Drain-Gebiet in der verbleibenden P-dotierten Innenzone (4) der N-dotierten Wanne (3), wobei das Source-Gebiet (12), das Drain-Gebiet (13) und der Kanalbereich (6) derart angeordnet werden, dass zwischen dem Kanalbereich und dem Drain-Gebiet die verbleibende P-dotierte Innenzone der Wanne als Driftzone (4) verbleibt, und

   Herstellen der mindestens einen NMOSFET-Halbleiterstruktur mit den folgenden Schritten:

   Aufbringen einer Maske (2) auf das P-dotierte Halbleitersubstrat (1) zur Definition eines von einer umlaufenden Kante (2b) begrenzten Fensters (2a),
   Erzeugen einer N-dotierten Wanne (15) in dem P-dotierten Halbleitersubstrat (I) mittels Hochvolt-Ionenimplantation, wobei die Energie der Ionenimplantation und die Breite des Fensters derart bemessen sind, dass sich die bis an die Oberfläche des Halbleitersubstrats reichenden Randzonen der N-dotierten Wanne an der Oberfläche des Halbleitersubstrats treffen, so dass an der Oberfläche des Halbleitersubstrats keine P-dotierte Innenzone verbleibt und
   Erzeugen eines N-dotierten Source-Gebietes (17), eines N-dotierten Drain-Gebietes (18) und eines P-dotierten Kanalbereichs (16) in dem P-dotierten Halbleitersubstrat, wobei das Source-Gebiet (17) das Drain-Gebiet (18) und der Kanalbereich (16) derart angeordnet werden, dass zwischen dem Kanalbereich und dem Drain-Gebiet die N-dotierte Wanne als Driftzone (15) verbleibt.

2. Verfahren nach Anspruch 1, **dadurch gekennzeichnet, dass** bei der Herstellung der mindestens einen PMOSFET-Halbleiterstruktur nach der Erzeugung der N-dotierten Wanne (3) der N-dotierte Kanalbereich (6) in der P-dotierten Innenzone (4) erzeugt wird.

3. Verfahren nach Anspruch 2, **dadurch gekennzeichnet, dass** bei der Herstellung der mindestens einen PMOSFET-Halbleiterstruktur auf den N-dotierten Kanalbereich (6) eine Isolator-Schicht (7) und auf der Isolator-Schicht eine Gate-Elektrode (9) aufgebracht wird.

4. Verfahren nach Anspruch 3, **dadurch gekennzeichnet, dass** bei der Herstellung der mindestens einen PMOSFET-Halbleiterstruktur auf die Gate-Elektrode (9) ein Gateanschluss (9') aufgebracht wird.

5. Verfahren nach Anspruch 3 oder 4, **dadurch gekennzeichnet, dass** bei der Herstellung der mindestens einen PMOSFET-Halbleiterstruktur das P-dotierte Source-Gebiet (12) in dem an die Gate-Elektrode (9) angrenzenden Bereich des N-dotierten Kanalbereichs (6) erzeugt wird.

6. Verfahren nach Anspruch 5, **dadurch gekennzeichnet, dass** bei der Herstellung der mindestens einen PMOSFET-Halbleiterstruktur auf das P-dotierte Source-Gebiet (12) und auf den an das P-dotierte Source-Grebiet angrenzenden Bereich des N-dotierten Kanalbereichs (6) ein Source/Bulk-Anschluss (11', 12') aufgebracht wird.

7. Verfahren nach Anspruch 6, **dadurch gekennzeichnet, dass** bei der Herstellung der mindestens einen PMOSFET-Halbleiterstruktur vor dem Aufbringen des Source/Bulk-Anschlusses (11', 12') in dem an das P-dotierte Source-Gebiet (12) angrenzenden Bereich des N-dotierten Kanalbereichs (6) eine $N^+$-dotierte Übergangszone (11) erzeugt wird.

8. Verfahren nach einem der Ansprüche 1 bis 7, **dadurch gekennzeichnet, dass** bei der Herstellung der mindestens einen PMOSFET-Halbleiterstruktur das P-dotierte Drain-Gebiet (13) in dem Bereich der P-dotierten Innenzone (4) erzeugt wird, der an den N-dotierten Kanalbereich (6) angrenzt.

9. Verfahren nach einem der Ansprüche 1 bis 8, **dadurch gekennzeichnet, dass** bei der Herstellung der mindestens einen PMOSFET-Halbleiterstruktur auf das P-dotierte Drain-Gebiet (13) ein Drain-Anschluss (13') aufgebracht wird.


**Claims**

1. Method of making a semiconductor device having at least one voltage-withstanding pMOSFET semiconductor structure and at least one nMOSFET semiconductor structure, beginning with a p-doped semiconductor structure and having the following steps:

   making of the at least one pMOSFET semiconductor structure by the following steps:

   application of a mask (2) to the p-doped semiconductor substrate (1) to define a window (2a) outlined by a surrounding edge (2b),
   production of an n-doped well (3) in the p-doped semiconductor substrate by means of high-voltage ion implantation, the energy of the ion implantation being of a size such that a p-doped inner zone (4) is left at the surface of the semiconductor substrate and the edge zone (5) of the n-doped well extends to the surface of the semiconductor substrate, and
   production of a p-doped source region (12), a p-doped drain region (13) and, between the p-doped source region and the p-doped drain region, an n-doped channel region (6), in the p-doped inner zone (4) that is left in the n-doped well (3), with the source region (12), the drain region (13) and the channel region (6) being so arranged that the remainder of the p-doped inner zone of the well is left between the channel region and the drain region as a drift zone (4), and

   making of the at least one nMOSFET semiconductor structure by the following steps:

   application of a mask (2) to the p-doped semiconductor substrate (1) to define a window (2a) outlined by a surrounding edge (2b),
   production of an n-doped well (15) in the p-doped semiconductor substrate (1) by means of high-voltage ion implantation, the energy of the ion implantation and the width of the window being of a size such that the edge zones of the n-doped well which extend to the surface of the semiconductor substrate meet at the surface of the semiconductor substrate, thus leaving no p-doped inner zone at the surface of the semiconductor substrate, and
   production of an n-doped source region (17), an n-doped drain region (18) and a p-doped channel region (16) in the p-doped semiconductor substrate, the source region (17), the drain region (18) and the channel region (16) being so arranged that the n-doped well is left between the channel region and the drain region as a drift zone (15).

2. Method according to claim 1, **characterised in that,** in the making of the at least one pMOSFET semiconductor structure, the n-doped channel region (6) is produced in the p-doped inner zone (4) after the production of the n-doped well (3).

3. Method according to claim 2, **characterised in that,** in the making of the at least one pMOSFET semiconductor structure, an insulator layer (7) is applied to the n-doped channel region (6) and a gate electrode (9) is applied to the insulator layer.

4. Method according to claim 3, **characterised in that,** in the making of the at least one pMOSFET semiconductor structure, a gate terminal (9') is applied to the gate electrode (9).

5. Method according to claim 3 or 4, **characterised in that,** in the making of the at least one pMOSFET semiconductor structure, the p-doped source region (12) is produced **in that** region of the n-doped channel region (6) which is adjacent the gate electrode (9).

6. Method according to claim 5, **characterised in that,** in the making of the at least one pMOSFET semiconductor structure, a source/bulk terminal (11', 12') is applied to the p-doped source region (12) and to that region of the n-doped channel region (6) which is adjacent the p-doped source region.

7. Method according to claim 6, **characterised in that,** in the making of the at least one pMOSFET semiconductor structure, an n+-doped transition zone (11) is produced in that region of the n-doped channel region (6) which is adjacent the p-doped source region (12), before the source/bulk terminal (11', 12') is applied.

8. Method according to one of claims 1 to 7, **characterised in that,** in the making of the at least one pMOSFET semiconductor structure, the p-doped drain region (13) is produced **in that** region of the p-doped inner zone (4) which is adjacent the n-doped channel region (6).

9. Method according to one of claims 1 to 8, **characterised in that,** in the making of the at least one pMOSFET semiconductor structure, a drain terminal (13') is applied to the p-doped drain region (13).

**Revendications**

1. Procédé de fabrication d'un dispositif semi-conducteur doté d'au moins une structure semi-conductrice PMOSFET à tenue en tension et d'au moins une structure semi-conductrice NMOSFET sur la base d'un substrat semi-conducteur dopé P, comportant les étapes suivantes :

    fabrication de la ou des structures semi-conductrices PMOSFET selon les étapes suivantes :

        application d'un masque (2) sur le substrat semi-conducteur dopé P (1) afin de définir une fenêtre (2a) limitée par un bord circulaire (2b),
        réalisation d'une cuve dopée N (3) dans le substrat semi-conducteur dopé P au moyen d'une implantation ionique à haute tension, l'énergie de l'implantation ionique est mesurée de manière telle qu'il reste une zone interne dopée P (4) à la surface du substrat semi-conducteur et que la zone périphérique (5) de la cuve dopée N s'étende jusqu'à la surface du substrat semi-conducteur et
        réalisation d'un secteur source dopé P (12), d'un secteur drain dopé P (13) et d'un secteur canal dopé N (6) entre le secteur source dopé P et le secteur drain dopé P dans la zone interne dopée P restante (4) de la cuve dopée N (3), le secteur source (12), le secteur drain (13) et le secteur canal (6) étant disposés de manière telle que la zone interne dopée P restante de la cuve reste entre le secteur canal et le secteur drain en tant que zone de dérive (4), et

    fabrication de la ou des structures semi-conductrices NMOSFET selon les étapes suivantes :

        application d'un masque (2) sur le substrat semi-conducteur dopé P (1) afin de définir une fenêtre (2a) limitée par un bord circulaire (2b),
        réalisation d'une cuve dopée N (15) dans le substrat semi-conducteur dopé P (1) au moyen d'une implantation ionique à haute tension, l'énergie de l'implantation ionique et la largeur de la fenêtre étant mesurée de manière telle que les zones périphériques de la cuve dopée N s'étendant jusqu'à la surface du substrat semi-conducteur se rencontrent à la surface du substrat semi-conducteur de sorte qu'il ne reste pas de zone interne dopée P à la surface du substrat semi-conducteur, et
        réalisation d'un secteur source dopé N (17), d'un secteur drain dopé N (18) et d'un secteur canal dopé P (16) dans le substrat semi-conducteur dopé P, le secteur source (17), le secteur drain (18) et le secteur canal (16) étant disposés de manière telle que la cuve dopée N reste en tant que zone de dérive (15) entre le secteur canal et le secteur drain.

2. Procédé selon la revendication 1, **caractérisé en ce que,** lors de la fabrication de la ou des structures semi-conductrices PMOSFET, le secteur canal dopé N (6) est réalisé dans la zone interne dopée P (4) après la réalisation de la cuve dopée N (3).

3. Procédé selon la revendication 2, **caractérisé en ce que,** lors de la fabrication de la ou des structures semi-conductrices PMOSFET, une couche d'isolation (7) est appliquée sur le secteur canal dopé N (6) et une électrode de grille (9) est appliquée sur la couche d'isolation.

4. Procédé selon la revendication 3, **caractérisé en ce que,** lors de la fabrication de la ou des structures semi-conductrices PMOSFET, un raccordement de grille (9') est appliqué sur l'électrode de grille (9).

5.  Procédé selon la revendication 3 ou 4, **caractérisé en ce que,** lors de la fabrication de la ou des structures semi-conductrices PMOSFET, le secteur source dopé P (12) est réalisé dans le secteur, contigu à l'électrode de grille (9), du secteur canal dopé N (6).

6.  Procédé selon la revendication 5, **caractérisé en ce que,** lors de la fabrication de la ou des structures semi-conductrices PMOSFET, un raccordement de source/substrat (11', 12') est appliqué sur le secteur source dopé P (12) et sur le secteur, contigu au secteur source dopé P, du secteur canal dopé N (6).

7.  Procédé selon la revendication 6, **caractérisé en ce que,** lors de la fabrication de la ou des structures semi-conductrices PMOSFET, avant l'application du raccordement source/substrat (11', 12'), il est réalisé une zone de passage dopée $N^+$ (11) dans le secteur, contigu au secteur source dopé P (12), du secteur canal dopé N (6).

8.  Procédé selon l'une quelconque des revendications 1 à 7, **caractérisé en ce que,** lors de la fabrication de la ou des structures semi-conductrices PMOSFET, le secteur drain dopé P (13) est réalisé dans le secteur (13) de la zone interne dopée P (4) qui est contigu au secteur canal dopé N (6).

9.  Procédé selon l'une quelconque des revendications 1 à 8, **caractérisé en ce que,** lors de la fabrication de la ou des structures semi-conductrices PMOSFET, un raccordement de drain (13") est appliqué sur le secteur drain dopé P (13).

N-Wannen Implantation

Maske

2a

2b

1    4

5    P⁻

N

3

P⁻

Fig. 1a

N-Bulk Implantation

4    Maske

6

5    P⁻

N

N

P⁻

Fig. 1b

Aktiv Ätzung

7 Isolator    Maske

6

5    P⁻

N

N

P⁻

Fig. 1c

Gateoxid  Maske

8   6   9 Poly

7 Isolator

Poly Ätzung

5    P⁻

N

N

P⁻

Fig. 1d

N+ Implantation

10   11 8 6 9 Poly

5   N+   N+   N   P⁻   5

N

P⁻

Fig. 1e

P+ Implantation

10   11 8 6 9 Poly

12   13

5   N+   N+   P+   N   P+   5

N

P⁻

Fig. 1f

Kontaktloch-Ätzung

10   11 12 6 Poly   13   14

5   N+   N+ P+   N   P+   5

N

P⁻

Fig. 1g

Metallisierung

N-Wanne   Source / Bulk   Gate   Drain
10'   11',12'   Poly   9'   13'

N+   N+ P+   N   P⁻   P+

N

P⁻

Fig. 1h

Fig. 2

N-Wannen Implantation

Fig. 3a

P-Bulk Implantation

Fig. 3b

Aktiv Ätzung

Fig. 3c

Poly Ätzung

16 Maske Isolator
21

P
P⁻          N          15          Fig. 3d

N+ Implantation

17 16 Isolator 18

N+ P    N    N+
P⁻                    Fig. 3e

P+ Implantation

19  17 16 Isolator 18

P+ N+  P    N    N+
P⁻                    Fig. 3f

Kontaktloch-Ätzung

19  17 16 21 Poly 14 18

P+ N+  P    N    N+
P⁻                    Fig. 3g

Metallisierung

Source / Bulk   Gate   Drain / N-Wanne
17', 19'   21'   18'

P+   N+   P   N   N+

P⁻

Fig. 3h

Bulk-Dotierung   N-Wanne

Gate

Bulkanschluß   Source   Kanalgebiet   Driftgebiet   Drain

19  17   21   18

16   15

Fig. 4a



Source / Bulk    Gate    Drain / N-Wanne
17',19'    21'    18'

SiO2

21

19 P+ 17 N+    P    N-    18 / N+
16 Driftzone
Kanaldotierung (Bulk)    15
gefüllte N-Wanne    P⁻    Fig. 4b
Substrat

Bulk-Dotierung    15

Gate

Bulkanschluß / Source / Kanalgebiet / Driftgebiet / Drain    15    gefüllte N-Wannen

19 17    18    15
16    21    Fig. 4c

Gate-Anschluß
21'    21    Poly-Si    SiO2    16
P Kanaldotierung (Bulk)
gefüllte N-Wanne    15    gefüllte N-Wanne    15    gefüllte N-Wanne    15
P⁻    Fig. 4d
Substrat

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 0019503 A1
- US 2003001206 A1
- US 20040063291 A1

**In der Beschreibung aufgeführte Nicht-Patentliteratur**

- **George R. Wilson.** Advances in Bipolar VLSI. *Proceedings ofthe IEEE,* 1990, vol. 78 (11), 1707-1719
- **U. Tietze ; Ch. Schenk.** Halbleiterschaltungstechnik. Springer, 1999, vol. 11, 214, 215
- **S. M. Sze.** Physics of semiconductor devices. Wiley & Sons, 1981, 100